# EUROPÄISCHE PATENTANMELDUNG

(11) **EP 4 497 857 A2**
(43) Veröffentlichungstag der Anmeldung: **29.01.2025**
(21) Anmeldenummer: 24217751.7
(22) Anmeldetag: 04.06.2018
(51) Int. Cl.: C30B 33/00

(54) **VERFAHREN, STEUERUNGSSYSTEM UND ANLAGE ZUM BEARBEITEN EINER HALBLEITERSCHEIBE SOWIE HALBLEITERSCHEIBE**

(30) Priorität: 21.06.2017 DE 102017210450
(62) Teilanmeldung aus: 18730680.8
(71) Anmelder: Siltronic AG, 81677 München (DE)
(72) Erfinder: Beyer, Axel, Seoul (Granciel 3cha, Bangbae-dong) (KR); Weber, Christof, 84489 Burghausen (DE); Welsch, Stefan, 84570 Polling (DE)

(57) **Zusammenfassung**

Die Erfindung betrifft eine Halbleiterscheibe (600), insbesondere Siliziumscheibe, mit einem ESFQRmax-Wert von höchstens 5 nm bei einem Randausschluss (R1) von höchstens 2 mm und 72 Sektoren (625) mit jeweils einer Länge (R2) von 30 mm.

## Beschreibung

Die vorliegende Erfindung betrifft ein Verfahren zum Bearbeiten einer Halbleiterscheibe, ein Steuerungssystem zum Steuern einer Beschichtungsvorrichtung zum Bearbeiten einer Halbleiterscheibe, eine Anlage zum Bearbeiten einer Halbleiterscheibe mit solchen Bearbeitungsvorrichtungen und einem solchen Steuerungssystem sowie eine Halbleiterscheibe.

### Stand der Technik

Halbleiterscheiben, insbesondere Siliziumscheiben, eignen sich beispielsweise für die Verwendung in der Halbleiterindustrie, insbesondere zur Fabrikation von hochintegrierten elektronischen Bauelementen wie beispielsweise Mikroprozessoren oder Speicherchips. Für die moderne Mikroelektronik werden Ausgangsmaterialien, sog. Substrate, mit hohen Anforderungen an globale und lokale Ebenheit, Randgeometrie, Dickenverteilung, einseiten-bezogene lokale Ebenheit, sog. Nanotopologie, und Defektfreiheit benötigt.

Um Halbleiterscheiben mit solchen Eigenschaften zu erhalten, können diese Halbleiterscheiben verschiedenen Bearbeitungsvorgängen unterzogen werden. Hierzu gehören insbesondere ein doppelseitiges Polieren (sog. DSP), bei dem beide Seiten einer Halbleiterscheibe gleichzeitig in einem Bearbeitungsschritt mittels zweier Arbeitsflächen materialabtragend bearbeitet werden und zwar vorzugsweise so, dass sich die vorder- und rückseitig während des Materialabtrags auf die Halbleiterscheibe wirkenden Bearbeitungskräfte im Wesentlichen ausgleichen und keine Zwangskräfte durch eine Führungsvorrichtung auf die Halbleiterscheibe ausgeübt werden, die Halbleiterscheibe also "frei schwimmend" (engl. "free floating") bearbeitet wird. Hierbei können insbesondere mehrere Halbleiterscheiben in einer oder mehreren sog. Läuferscheiben, die Ausnehmungen für die Halbleiterscheiben aufweisen, eingelegt und dann durch beidseitig auf die Halbleiterscheiben wirkende Kräfte poliert werden. Eine DSP-Bearbeitung von Siliziumscheiben ist beispielsweise beschrieben in US 2003/054650 A1 und eine dafür geeignete Vorrichtung in DE 100 07 390 A1.

Als weiterer Bearbeitungsvorgang kommt ein chemisch-mechanisches Polieren (sog. CMP) in Betracht, wie es beispielswiese aus der DE 10 2008 045 534 B4 bekannt ist. Hierbei wird eine Halbleiterscheibe mittels eines Trägers auf ein Poliertuch (das sich auf einem Polierteller befinden kann) gedrückt und dann unter Druck meist rotierend bewegt. Durch die Verwendung eines geeigneten Poliermittels bzw. einer Poliermittelsuspension wird dann eine Seite der Halbleiterscheibe poliert.

Als weiterer Bearbeitungsvorgang kommt ein Beschichtungsvorgang in Betracht, wie er beispielsweise aus der DE 10 2005 045 339 A1 bekannt ist. Bei einem epitaktischen Beschichten von Halbleiterscheiben wird beispielsweise in einem Epitaxie-Reaktor ein Abscheidegas durch den Epitaxie-Reaktor geleitet, wodurch sich auf einer Oberfläche der Halbleiterscheiben epitaktisch Material abscheiden kann. Außer auf den Halbleiterscheiben scheidet sich das Material jedoch auch im Inneren des Epitaxie-Reaktors ab. Daher ist es üblicherweise notwendig, solche Rückstände, die sich während des Abscheidens auf Oberflächen im Epitaxie-Reaktor unkontrolliert abgelagert haben, von Zeit zu Zeit zu entfernen.

Bei allen oben genannten Bearbeitungsschritten treten Ungleichmäßigkeiten auf, sowohl in radialer, als auch in Umfangsrichtung. Als prominentes Beispiel sei hier die sogenannte Vierfach-Symmetrie der epitaktisch abgeschiedenen Schicht genannt, die durch unterschiedliche Aufwachsgeschwindigkeiten entlang unterschiedlicher Kristallachsen mit verursacht wird.

Vor diesem Hintergrund stellt sich die Aufgabe, eine Möglichkeit anzugeben, noch bessere Halbleiterscheiben, insbesondere hinsichtlich der Ebenheit ihrer Oberfläche, zu erhalten.

### Offenbarung der Erfindung

Es werden ein Verfahren, ein Steuerungssystem und eine Anlage zum Bearbeiten einer Halbleiterscheibe sowie eine erfinderische Halbleiterscheibe mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung geht aus von einem Verfahren zum Bearbeiten einer Halbleiterscheibe, bei dem die Halbleiterscheibe auf einem Suszeptor in einer Beschichtungsvorrichtung angeordnet wird. Als Beschichtungsvorrichtung kommt dabei insbesondere ein Epitaxie-Reaktor in Betracht. Das Verfahren umfasst dabei einen oder mehrere Bearbeitungsvorgänge, wobei ein solcher Bearbeitungsvorgang einen Ätzschritt und gegebenenfalls einen Abscheideschritt umfasst. Im Zuge des Ätzschritts wird dabei ein Ätzgas durch die Beschichtungsvorrichtung geleitet. Das Ätzgas besteht vorzugsweise aus einer Mischung von Chlorwasserstoff und Wasserstoff, wobei das Ätzgas auch nur aus Chlorwasserstoff oder nur aus Wasserstoff bestehen kann.

Im Zuge des gegebenenfalls durchgeführten Abscheideschritts wird ein Abscheidegas zum epitaktischen Abscheiden einer Schicht auf der Halbleiterscheibe durch die Beschichtungsvorrichtung geleitet. Als Abscheidegas kommt dabei insbesondere Trichlorsilan in Betracht. Bevorzugt ist insbesondere, wenn der Bearbeitungsvorgang den Ätzschritt und anschließend den Abscheideschritt umfassen.

Der Ätzschritt kann dazu dienen, etwaige Ablagerungen bzw. Abscheidungen in der Beschichtungsvorrichtung bzw. im Epitaxie-Reaktor, die von einem vorausgehenden Abscheideschritt stammen, zumindest teilweise zu entfernen.

Solche Ablagerungen beeinflussen den Fluss von Gas in der Beschichtungsvorrichtung sowie Temperatur-Gradienten und damit auch die durch das Abscheidegas epitaktisch abscheidbare Schicht auf der Halbleiterscheibe. Der Ätzschritt kann auch dazu genutzt werden, zu erreichen, dass ein Abtrag in der Mitte der Halbleiterscheibe höher ist als am Rand.

Es hat sich nun herausgestellt, dass unter den im Rahmen dieser Erfindung gewählten Bedingungen beim Ätzschritt auf der von dem Suszeptor abgewandten Seite der Halbleiterscheibe Material abgetragen wird, sich jedoch auf der dem Suszeptor zugewandten Seite Material abscheidet, insbesondere im Randbereich bzw. im Bereich, in dem die Halbleiterscheibe am Suszeptor aufliegt. Dies kommt insbesondere dadurch zustande, dass durch das Ätzgas in der Beschichtungsvorrichtung vorhandenes, beispielsweise bei einem vorausgehenden Abscheidungsvorgang abgeschiedenes, Material (im Rahmen einer Gleichgewichtsreaktion) gelöst und an der Halbleiterscheibe wieder abgeschieden wird bzw. dadurch, dass sich auf dem Suszeptor befindliches Material aus einem vorhergehenden Bearbeitungsschritt mit dem Material der zu bearbeitenden Scheibe verbindet und beim Entladen der Beschichtungsvorrichtung mitgerissen wird.

Es ist nun vorgesehen, dass eine von zwei Seiten der Halbleiterscheibe vor dem Bearbeitungsvorgang mit einer Schutzschicht beschichtet wird. Es wird eine erste Seite (FS) der Halbleiterscheibe, die einem Poliervorgang durch CMP (Chemical Mechanical Polishing) unterzogen worden ist, oder eine zweite Seite (BS) der Halbleiterscheibe, die der ersten Seite gegenüberliegt und einem Poliervorgang durch CMP unterzogen worden sein kann, beschichtet. Vorzugsweise handelt es sich bei der Halbleiterscheibe, die mit der Schutzschicht beschichtet wird um eine Halbleiterscheibe, deren erste und zweite Seite gleichzeitig durch Doppelseitenpolitur (DSP) poliert wurden und deren erste Seite (FS) im Anschluss an die Doppelseitenpolitur in einem Poliervorgang durch CMP poliert wurde. Die Halbleiterscheibe ist vorzugsweise eine Halbleiterscheibe aus einkristallinem Silizium und hat vorzugsweise einen Durchmesser von nicht weniger als 200 mm, besonders bevorzugt einen Durchmesser von nicht weniger als 300 mm. Als Schutzschicht kommt bevorzugt eine Oxid-Schicht, insbesondere eine Niedertemperatur-Oxid-Schicht (LTO, von engl. Low Temperatur Oxide) in Betracht. Mit dem Begriff Niedertemperatur-Oxid-Schicht bzw. LTO wird hierbei eine nach einem bestimmten Verfahren aufgebrachte Oxid-Schicht bezeichnet. Denkbar ist beispielsweise Siliziumdioxid. Eine Dicke der Schicht kann insbesondere höchstens 200 nm, bevorzugt höchstens 150 nm, besonders bevorzugt höchstens 100 nm, betragen, um besonders gute Ergebnisse zu erzielen. Die Schutzschicht kann zudem zweckmäßigerweise mit einem Randausschluss von höchstens 0,5 mm, bevorzugt höchstens 0,2 mm, besonders bevorzugt höchstens 0,1 mm gebildet werden, d.h. es wird ein entsprechender Bereich am Rand der Halbleiterscheibe nicht mit der Schutzschicht beschichtet bzw. bedeckt. Der Ätzschritt kann dann zweckmäßigerweise bei einer Temperatur zwischen 1.000°C und 1.250°C, bevorzugt zwischen 1.100°C und 1.150°C, in der Beschichtungsvorrichtung vorgenommen werden. Die Schutzschicht kann aber auch eine Schutzschicht aus Siliziumdioxid sein, die durch eine RTA-Wärmebehandlung (Rapid Thermal Anneal) erzeugt wird.

Die Gegenwart der Schutzschicht auf der ersten Seite (FS) oder der zweiten Seite (BS) verhindert, dass beim Ätzschritt Material von der mit der Schutzschicht versehenen Seite der Halbleiterscheibe abgetragen wird. Dabei wird ausgenutzt, dass beispielsweise ein Oxid eines Halbleitermaterials deutlich weniger durch das Ätzgas angegriffen und damit abgetragen wird, als das zugehörige, reine Halbleitermaterial. Außerdem wird auch der eingangs beschriebene Materialtransport bei Kontakt mit dem Suszeptor sowie eine Materialabscheidung durch die Schutzschicht verhindert.

Befindet sich die Schutzschicht auf derjenigen Seite, die während des Ätzschritts vom Suszeptor abgewandt ist, unterbleibt der Vorgang, dass Material von dieser Seite abgetragen wird. Gemäß einer ersten bevorzugten Ausführungsform ist die erste Seite (FS) diejenige Seite, die mit der Schutzschicht versehen ist und die zweite Seite (BS) diejenige, die während des Ätzschritts dem Suszeptor zugewandt liegt. Der Ätzschritt wird in diesem Fall herangezogen, um Material insbesondere im Randbereich der zweiten Seite (BS) abzuscheiden. Nach dem Ätzschritt und dem Entfernen der Schutzschicht kann auf der ersten Seite (FS) eine epitaktische Schicht abgeschieden werden.

Befindet sich die Schutzschicht während des Ätzschritts auf derjenigen Seite, die während des Ätzschritts dem Suszeptor zugewandt ist, unterbleibt der Vorgang, dass sich Material insbesondere im Randbereich dieser Seite abscheidet. Gemäß einer zweiten bevorzugten Ausführungsform ist die zweite Seite (BS) diejenige Seite, die mit der Schutzschicht versehen ist und die während des Ätzschritts dem Suszeptor zugewandt liegt. Der Ätzschritt wird in diesem Fall herangezogen, um Material von der ersten Seite (FS) zu entfernen. Vorzugsweise folgt dem Ätzschritt ein Abscheideschritt, im Zuge dessen eine epitaktische Schicht auf der ersten Seite (FS) abgeschieden wird. Die Schutzschicht wird vor oder nach dem Abscheiden der epitaktischen Schicht entfernt.

Gemäß einer dritten bevorzugten Ausführungsform ist der Bearbeitungsvorgang in einen ersten Ätzschritt und in einen zweiten Ätzschritt untergliedert, und nach dem zweiten Ätzschritt folgt ein Abscheideschritt, im Zuge dessen eine epitaktische Schicht auf der ersten Seite (FS) abgeschieden wird. Während des ersten Ätzschritts ist die erste Seite (FS) diejenige Seite, die mit der Schutzschicht versehen ist und die zweite Seite (BS) diejenige, die während des ersten Ätzschritts dem Suszeptor zugewandt liegt. Nach dem ersten Ätzschritt wird die Schutzschicht von der ersten Seite (FS) entfernt und die zweite Seite (BS) mit der Schutzschicht versehen. Während des zweiten Ätzschritts ist die zweite Seite (BS) diejenige Seite, die mit der Schutzschicht versehen ist und die dem Suszeptor zugewandt liegt. Die Schutzschicht wird von der zweiten Seite (BS) nach dem zweiten Ätzschritt oder nach dem Abscheiden der epitaktischen Schicht auf der ersten Seite (FS) der Halbleiterscheibe entfernt.

Wird das Verfahren gemäß einer der beschriebenen Ausführungsformen durchgeführt, lassen sich die beiden Seiten der Halbleiterscheibe unabhängig voneinander und kontrolliert bearbeiten.

Die zweite bevorzugte Ausführungsform eignet sich insbesondere, um einer im Randbereich der Halbleiterscheibe nach Beschichten der Halbleiterscheibe mit einer epitaktischen Schicht auftretenden symmetrischen Dickenschwankung entgegenzuwirken. Die Dickenschwankung ist dem Umstand geschuldet, dass beim Abscheiden der epitaktischen Schicht Material im Randbereich abhängig vom Polarwinkel mit unterschiedlichen Geschwindigkeiten abgeschieden wird. Beispielsweise wächst auf einer {100}-orientierten Halbleiterscheibe aus einkristallinem Silizium mit einer Orientierungskerbe (notch), die eine <110>-Richtung kennzeichnet und die Polarwinkel-Position von 0° bezeichnet, eine epitaktische Schicht aus einkristallinem Silizium an Polarwinkel-Positionen von 0°, 90°, 180° und 270° ohne zusätzliche Maßnahmen schneller, als an Polarwinkel-Positionen, die zu den genannten Positionen um 45° versetzt liegen. Die Dicke der epitaktisch beschichteten Halbleiterscheibe ist deshalb in vier Bereichen des Umfangs, die gleiche Abstände zueinander haben, größer, als in den dazwischen liegenden Bereichen (sog. Vierfach-Symmetrie).

Es wurde festgestellt, dass sich die Dicke der epitaktisch beschichteten Halbleiterscheibe im Randbereich vergleichmäßigen lässt, wenn vor dem Abscheiden der epitaktischen Schicht das Verfahren gemäß der zweiten bevorzugten Ausführungsform durchgeführt wird. Die Geschwindigkeit des Materialabtrags, der im Zuge des Ätzschritts auf der ersten Seite (FS) stattfindet, ist im Randbereich an denjenigen Stellen größer, an denen während des Abscheidens der epitaktischen Schicht Material mit der höheren Geschwindigkeit abgeschieden wird. Dieser im Zuge des Ätzschritts auftretende Effekt wird nachfolgend als Anti-Vierfach-Symmetrie-Ätzen (4FSE) bezeichnet. Der lokal zu erzielende Materialabtrag richtet sich insbesondere nach der Dauer des Ätzschritts. So kann die Vorgehensweise gemäß der zweiten bevorzugten Ausführungsform in Kombination mit dem Abscheiden einer epitaktischen Schicht eingesetzt werden, um eine epitaktisch beschichtete Halbleiterscheibe mit einem gleichmäßigeren Dickenverlauf in Umfangsrichtung zu erhalten.

Die zweite bevorzugte Ausführungsform wird daher vorzugsweise herangezogen, um eine Halbleiterscheibe aus Silizium herzustellen, bei der die erste Seite (FS) mit einer epitaktischen Schicht aus Silizium beschichtet ist und bei der die erste Seite (FS) eine {100}-Orientierung oder eine {110}-Orientierung hat.

Die erste bevorzugte Ausführungsform eignet sich insbesondere, um einem Randabfall entgegenzuwirken, der durch DSP und gegebenenfalls durch CMP der ersten Seite (FS) und/oder zweiten Seite (BS) verursacht wurde. Das im Randbereich der zweiten Seite (BS) abgeschiedene Material erhöht lokal die Dicke der Halbleiterscheibe und sorgt dafür, dass der radiale Verlauf der Dicke vergleichmäßigt wird. Die Menge und Lage des abgeschiedenen Materials lässt sich durch Konfigurieren des Suszeptors und die Dauer des Ätzschritts beeinflussen. Zumindest in einem Zeitraum von 60 s Ätzdauer ist ein linearer Zuwachs von abgeschiedenem Material zu beobachten. Der Suszeptor weist vorzugsweise eine abfallend geneigte Ablagefläche (ledge) auf, auf der die Halbleiterscheibe im Randbereich aufliegt. Die radiale Breite der Ablagefläche und der Neigungswinkel der Ablagefläche sind Einflussgrößen, die beim Konfigurieren des Suszeptors insbesondere berücksichtigt werden sollten.

Die dritte bevorzugte Ausführungsform umfasst im Wesentlichen eine Kombination der ersten bevorzugten Ausführungsform und der zweiten bevorzugten Ausführungsform.

Während des Ätzschritts beziehungsweise während des ersten und des zweiten Ätzschritts beträgt der Volumenstrom von Chlorwasserstoff vorzugsweise nicht weniger als 2 slm und nicht mehr als 5 slm, der Volumenstrom von Wasserstoff vorzugsweise nicht weniger als 30 slm und nicht mehr als 110 slm, besonders bevorzugt nicht weniger als 40 slm und nicht mehr als 70 slm (Standard Liter pro Minute). Besonders glatte Oberflächen resultieren bei einem Volumenstrom von Chlorwasserstoff von 4 slm und einem Volumenstrom von Wasserstoff von 50 slm. Durch diese Gasflüsse kann bspw. erreicht werden, dass ein Abtrag in der Mitte der Halbleiterscheibe höher ist als am Rand.

Das vorgeschlagene Verfahren erlaubt im Hinblick auf das Anti-Vierfach-Symmetrie-Ätzen (4FSE) eine Reduzierung der Vierfach-Symmetrie nach dem Beschichten, wobei längere Zeitdauern des Ätzschritts (mit Fluss von Ätzgas) zu kleinerer verbleibender Vierfach-Symmetrie führen. Eine maximal mögliche Zeitdauer im Ablauf ergibt sich herkömmlicherweise aus der Tatsache, dass die Ablagerung auf der zweiten Seite (BS) bei zu langen Zeitdauern des Ätzschritts zu einer Verschlechterung der lokalen Geometrie (Ebenheit) der Halbleiterscheibe führt. Dieses Problem wird hier durch die Schutzschicht gelöst, da die unerwünschte Materialabscheidung unterdrückt wird. Weiterhin lässt sich durch geschickte Kombination der bei Bearbeitung mit der Beschichtungsvorrichtung und anderen, vorausgehenden Poliervorgängen auftretenden Inhomogenitäten eine deutlich bessere Flachheit nahe am Rand erreichen als bislang.

Es sei angemerkt, dass ein Bearbeitungsvorgang nach dem Ätzschritt auch - wie üblich - einen Abscheideschritt umfassen kann, bei dem dann auch die Schutzschicht vorhanden ist. Jedoch kann auch nur ein Ätzschritt verwendet werden, um gezielt nur Material abzutragen, nicht jedoch erneut Material abzuscheiden. Denkbar ist im Falle mehrerer Bearbeitungsvorgänge auch, nur bei einigen der Bearbeitungsvorgänge, also beispielsweise nur beim ersten von zwei, den Abscheideschritt durchzuführen.

Mit dem vorgeschlagenen Verfahren können nun Halbleiterscheiben, insbesondere Siliziumscheiben, erhalten werden, die deutlich bessere Werte hinsichtlich der eingangs genannten Anforderungen aufweisen. Eine solche Halbleiterscheibe kann eine Halbleiterscheibe aus einkristallinem Silizium sein, mit wenigstens einer Seitenfläche, die durch CMP poliert ist oder eine Halbleiterscheibe aus einkristallinem Silizium sein, die mit einer Schicht aus einkristallinem Silizium epitaktisch beschichtet ist. Die Halbleiterscheibe hat einen ESFQRₘₐₓ-Wert, der höchstens 5 nm beträgt bei einem Randausschluss von höchstens 2 mm und 72 Sektoren mit jeweils einer Länge von 30 mm. Vorzugsweise hat die Halbleiterscheibe einen ESFQRₘₐₓ-Wert höchstens 10 nm bei einem Randausschluss von höchstens 1 mm und 72 Sektoren mit jeweils einer Länge von 30 mm. Besonders bevorzugt ist, dass die Halbleiterscheibe einen ESFQRₘₐₓ-Wert höchstens 15 nm hat bei einem Randausschluss von höchstens 0,5 mm und 72 Sektoren mit jeweils einer Länge von 30 mm. Solche Halbleiterscheiben sind dabei auch Gegenstand der vorliegenden Erfindung.

SFQR steht dabei für "Site Frontsurface-referenced least sQuares/Range" und dessen Wert gibt die Flachheit der Halbleiterscheibe an. Insbesondere werden damit positive und negative Abweichungen einer Oberfläche von einer ebenen Referenzfläche zusammengefasst. In der Regel werden dabei die Abweichungen jeweils für eine Fläche mit bestimmten Abmessungen an der Oberfläche der Halbleiterscheibe zur Berechnung herangezogen. ESFQR steht für "Edge Site Frontsurface-referenced least sQuares/Range" und dessen Wert ist ebenso wie der SFQR-Wert definiert, jedoch nur für einen Randbereich der Halbleiterscheibe. ESFQDₐᵥ steht für "Edge Site Frontsurface-referenced least sQuares/Deviation" und der Index av bezeichnet den Mittelwert der ESFQD-Werte von Rand-Teilbereichen (edge sites) im Umfangsbereich der Halbleiterscheibe. Üblicherweise umfasst der Umfangsbereich 72 solcher Teilbereiche (Sektoren).

Definitionen und Messvorschriften für die genannten Scheibenparameter sind in den Normen SEMI M67 (ESFQR und ESFQD) und SEMI M1, 5 SEMI MF1530 und SEMI M49 (SFQR) enthalten.

Ein weiterer Vorteil der Schutzschicht ist, wenn sie während eines Abscheideschritts auf dem Suszeptor aufliegt, dass die Halbleiterscheibe nicht auf dem Suszeptor festwachsen kann. Der Grund hierfür liegt darin, dass die Schutzschicht ein anderes Material aufweist. Beispielsweise verbindet sich Siliziumdioxid kaum mit Silizium. Damit kann erreicht werden, dass bei Entfernen der Halbleiterscheibe vom Suszeptor kein Material vom Suszeptor mit entfernt wird und damit insbesondere keine oder zumindest deutlich geringere Spannungen in der Halbleiterscheibe, insbesondere im Randbereich, auftreten. Dieser Effekt tritt bereits beim Erwärmen der Beschichtungsvorrichtung auf, d.h. unabhängig davon, ob ein Ätzschritt oder ein Abscheideschritt durchgeführt wird oder nicht.

Vorzugsweise wird die Schutzschicht nach einem Bearbeitungsvorgang - insbesondere in Abhängigkeit davon, was nachfolgend mit der Halbleiterscheibe passieren soll - von der Halbleiterscheibe wieder entfernt. Dann kann beispielsweise ein weiterer Bearbeitungsvorgang erfolgen, vor dem die andere Seite mit der Schutzschicht versehen wird. Am Ende aller mit der Beschichtungsvorrichtung durchzuführenden Bearbeitungsvorgänge kann die Schutzschicht entfernt werden, um die fertige Halbleiterscheibe zu erhalten. Die Schutzschicht kann, insbesondere im Falle einer Oxid-Schicht auf einer Siliziumscheibe, beispielsweise unter der Verwendung von Flusssäure (HF) entfernt werden, da Flusssäure zwar das Oxid, nicht jedoch Silizium löst.

Besonders bevorzugt ist es auch, wenn die Halbleiterscheibe vor dem einen oder den mehreren Bearbeitungsvorgängen in einem oder mehreren Poliervorgängen mit einer Poliervorrichtung auf wenigstens einer der zwei Seiten poliert wird. Zweckmäßig ist hier die eingangs erwähnte Poliervorrichtung für chemisch-mechanisches Polieren (CMP), die eine gezielte Bearbeitung nur einer Seite erlaubt. Insbesondere kann dabei derart poliert werden, dass in radialer Richtung der Halbleiterscheibe Bereiche bei der Bearbeitung unterschiedlich stark beeinflusst werden, insbesondere jeweils durch Vorgabe unterschiedlicher Drücke auf die Bereiche der Halbleiterscheibe.

Solche unterschiedlichen Drücke können dabei beispielsweise durch einen geeignet ausgebildeten Träger der zugehörigen Poliervorrichtung, durch den der Druck auf die Halbleiterscheibe ausgeübt wird, erzeugt werden. Es kann also der Druck für einzelne Bereiche oder auch Zonen der Halbleiterscheibe gezielt vorgegeben wird. Es lassen sich dabei also Rezepte (für die zugehörigen Betriebsparameter der Poliervorrichtung) individuell für jede Halbleiterscheibe vorgeben. Damit kann insbesondere den ungewünschten Komponenten des im nachfolgenden Bearbeitungsvorgang in der Beschichtungsvorrichtung auftretenden Materialaufbaus am Rand der Halbleiterscheibe entgegengewirkt werden.

Besonders vorteilhaft ist es dabei, wenn wenigstens ein Betriebsparameter eines Poliervorgangs in Abhängigkeit von wenigstens einem Betriebsparameter des Bearbeitungsvorgangs und/oder in Abhängigkeit von einem durch den Poliervorgang oder Bearbeitungsvorgang zu erwartenden Scheibenparameter vorgegeben wird. Als Scheibenparameter kommt dabei beispielsweise der ESFQDₐᵥ-Wert oder ein anderer Parameter, mit dem die Ebenheit bzw. Flachheit angegeben werden kann, in Frage. Auf diese Weise lassen sich also gezielt Wechselwirkungen zwischen dem Poliervorgang einerseits und dem Bearbeitungsvorgang in der Beschichtungsvorrichtung andererseits ausnutzen, um insgesamt flachere Halbleiterscheiben zu erzielen. Insbesondere lassen sich nämlich etwaige, nachteilige Abtragungen im Poliervorgang gezielt beim Beschichten ausgleichen und umgekehrt. Vor allem können auf diese Weise auch Betriebsparameter für die einzelnen Vorrichtungen in Betracht gezogen werden, die bei herkömmlichen Verfahren, bei denen jede Vorrichtung einzeln optimiert wird, nicht in Betracht gezogen würden, da sie beispielsweise zu schlechteren Ergebnisse für die einzelne Vorrichtung an sich liefern würden. Dies tritt jedoch bei kombinierter Betrachtung mehrerer Vorrichtungen nicht mehr zu.

Der Vollständigkeit halber sei noch angemerkt, dass vor einem Poliervorgang für chemisch-mechanisches Polieren auch noch ein Poliervorgang für doppelseitiges Polieren (wie eingangs erwähnt) vorgesehen sein kann. Auch dieser Poliervorgang kann dann hinsichtlich seiner Betriebsparameter bei den anderen Polier-und/oder Bearbeitungsvorgängen und deren Betriebsparameter berücksichtigt werden.

Es gibt ein Steuerungssystem zum Steuern einer Beschichtungsvorrichtung zum Bearbeiten einer Halbleiterscheibe, in der in einem Bearbeitungsvorgang ein Ätzgas durchgeleitet und/oder auf der Halbleiterscheibe epitaktisch eine Schicht abgeschieden werden kann, und insbesondere auch zum Steuern einer Poliervorrichtung, in der in einem Poliervorgang die Halbleiterscheibe poliert werden kann. Dabei ist das Steuerungssystem dazu eingerichtet ist, bei Verwendung mit der Beschichtungsvorrichtung, und insbesondere auch der Poliervorrichtung, ein Verfahren durchzuführen.

Es gibt eine Anlage zum Bearbeiten einer Halbleiterscheibe mit einer Beschichtungsvorrichtung, in der in einem Bearbeitungsvorgang ein Ätzgas durchgeleitet und/oder auf der Halbleiterscheibe epitaktisch eine Schicht abgeschieden werden kann, und insbesondere auch mit einer Poliervorrichtung, in der in einem Poliervorgang die Halbleiterscheibe poliert werden kann, weiterhin mit einem Steuerungssystem.

Hinsichtlich weiterer Ausgestaltungen und Vorteile des Steuerungssystems und der Anlage sei zur Vermeidung von Wiederholungen auf die Ausführungen des vorgeschlagenen Verfahrens verwiesen, die hier entsprechend gelten.

Weitere Vorteile und Ausgestaltungen ergeben sich aus der Beschreibung und den beiliegenden Zeichnungen.

Die Erfindung wird im Folgenden unter Bezugnahme auf Zeichnungen beschrieben.

### Figurenbeschreibung

- Figur 1: zeigt schematisch eine Anlage in einer bevorzugten Ausführungsform, mit welcher ein Verfahren durchführbar ist.
- Figur 2: zeigt schematisch eine erste Poliervorrichtung, wie sie im Rahmen eines Verfahrens verwendet werden kann.
- Figur 3: zeigt schematisch eine zweite Poliervorrichtung, wie sie im Rahmen eines Verfahrens verwendet werden kann.
- Figur 4: zeigt schematisch eine Beschichtungsvorrichtung, wie sie im Rahmen eines Verfahrens verwendet werden kann.

- Figur 5: zeigt schematisch eine Halbleiterscheibe mit Schutzschicht in verschiedenen Ansichten.
- Figur 6: zeigt schematisch den Verlauf des Dickenunterschieds über den Durchmesser von zwei Halbleiterscheiben nach Durchlaufen eines Ätzschritts in einer Beschichtungsvorrichtung im Rahmen eines Verfahrens.
- Figur 7: zeigt schematisch den Verlauf des Dickenunterschieds über den Umfang einer Halbleiterscheibe nach Durchlaufen eines Ätzschritts in einer Beschichtungsvorrichtung im Rahmen eines Verfahrens.
- Figur 8: zeigt schematisch die Abläufe von drei bevorzugten Ausführungsformen des Verfahrens.
- Figur 9 und Figur 10: zeigen Messergebnisse von zwei epitaktisch beschichteten Halbleiterscheiben und zwar Dickenunterschiede im Randbereich betreffend.
- Figur 11: zeigt ein Ablaufschema zur Steuerung von Betriebsparametern.

### Detaillierte Beschreibung der Zeichnungen

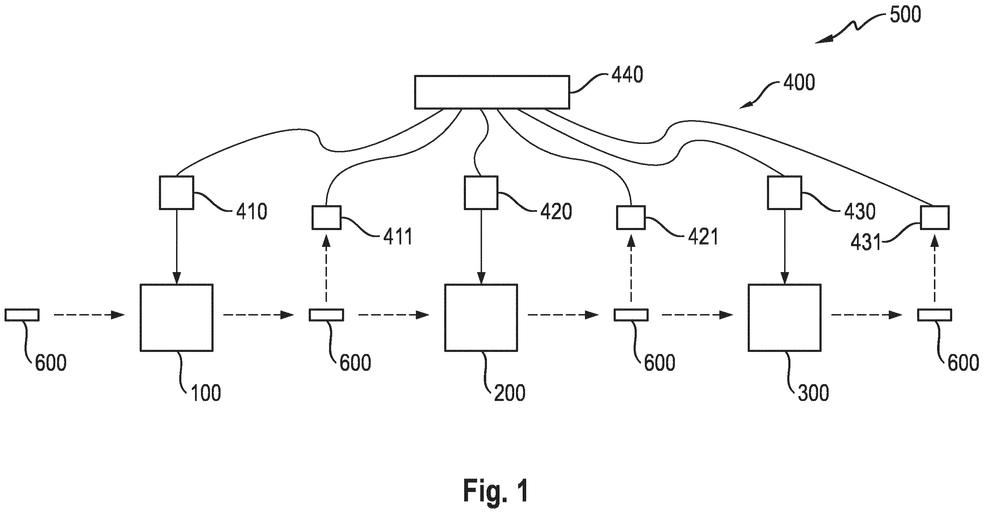

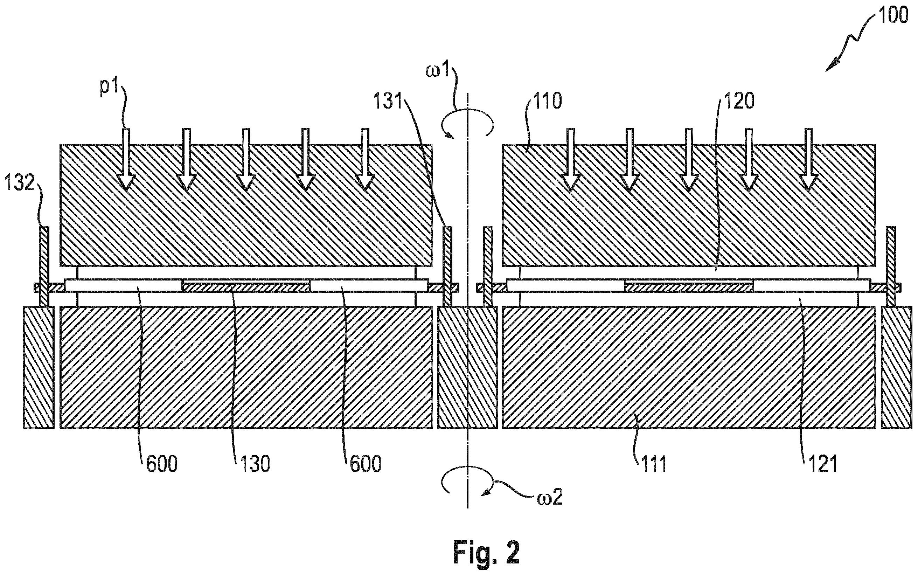

In Figur 1 ist schematisch eine Anlage 500 in einer bevorzugten Ausführungsform dargestellt, mit der ein Verfahren durchführbar ist. Die Anlage 500 dient zum Bearbeiten einer Halbleiterscheibe 600 und umfasst als Bearbeitungsvorrichtungen eine erste Poliervorrichtung 100, eine zweite Poliervorrichtung 200 und eine Beschichtungsvorrichtung 300. Diese drei Bearbeitungsvorrichtungen dienen der Bearbeitung einer Halbleiterscheibe 600, die nacheinander die einzelnen Bearbeitungsvorrichtungen durchlaufen kann. Der Vollständigkeit halber sei an dieser Stelle nochmals erwähnt, dass vor, zwischen und/oder nach den Bearbeitungsvorrichtungen auch weitere Bearbeitungsvorrichtungen vorgesehen sein können, die jedoch nicht oder zumindest kaum relevant sind. Relevant sind dabei insbesondere die Beschichtungsvorrichtung 300 und - je nach Ausführungsform - auch die zweite Poliervorrichtung 200, im Übrigen auch nur als Poliervorrichtung bezeichnet. Nichtsdestotrotz kann die Bearbeitung der Halbleiterscheibe auch unter Verwendung der hier gezeigten ersten Poliervorrichtung 100 erfolgen, was insbesondere auch üblich ist. Für eine detailliertere Beschreibung der einzelnen Bearbeitungsvorrichtungen sei an dieser Stelle auf die Figuren 2 bis 4 verwiesen.

Weiterhin umfasst die Anlage 500 ein Steuerungssystem 400, das zusammen mit den drei gezeigten Bearbeitungsvorrichtungen verwendet werden kann, um diese anzusteuern bzw. zu betreiben. Im gezeigten Beispiel umfasst das Steuerungssystem 400 drei einzelne Steuereinheiten 410, 420 und 430, die jeweils zur Ansteuerung bzw. zum Betrieb einer der drei Bearbeitungsvorrichtungen vorgesehen sind. Über die jeweilige Steuereinheit kann dabei insbesondere jeweils wenigstens ein Betriebsparameter für die jeweilige Bearbeitungsvorrichtung vorgegeben bzw. eingestellt werden.

Zu jeder der Steuereinheiten 410, 420 und 430 ist zudem jeweils eine Messvorrichtung 411, 421 bzw. 431 vorgesehen. Mittels dieser Messvorrichtungen kann eine Halbleiterscheibe, nachdem sie in der jeweiligen Bearbeitungsvorrichtung bearbeitet wurde, hinsichtlich wenigstens eines Scheibenparameters vermessen werden. Es versteht sich, dass solche Messvorrichtungen - je nach Anwendung - auch in die jeweilige Steuereinheit integriert sein können.

Zudem ist hier eine zentrale Steuereinheit 440 dargestellt, die mit jeder der Steuereinheiten 410, 420 und 430 und mit jeder der Messvorrichtungen 411, 421 und 431 verbunden ist. Eine solche Verbindung umfasst dabei zumindest eine Verbindung zur Datenübertragung, beispielsweise drahtgebunden oder drahtlos. Die von den einzelnen Messvorrichtungen 411, 421 bzw. 431 ermitteln Werte können auf diese Weise an die zentrale Steuereinheit 440 übertragen werden, sodass mittels der zentralen Steuereinheit 440 dann geeignete Betriebsparameter für die jeweiligen Bearbeitungsvorrichtungen ermittelt werden können, welche dann an die jeweilige Steuereinheit 410, 420 bzw. 430 übertragen werden können. Es versteht sich, dass die Ermittlung der jeweiligen Betriebsparameter auch auf andere Weise, beispielsweise direkt in einer der einzelnen Steuereinheiten, erfolgen kann.

In Figur 2 ist schematisch und detaillierter als in Figur 1 eine erste Poliervorrichtung 100 (für DSP) im Querschnitt dargestellt. Hierbei sind vier Halbleiterscheiben 600 (wovon nur zwei in der linken Hälfte mit einem Bezugszeichen versehen sind) in entsprechende Aussparungen von Läuferscheiben 130, die mittels eines inneren Zahnkranzes 131 und eines äußeren Zahnkranzes 132, einer sog. Abwälzvorrichtung, bewegt werden, zwischen einem oberen Polierteller 110 und einem unteren Polierteller 111 eingebracht.

Auf dem unteren Polierteller 111 befindet sich ein Poliertuch 121. Auf dem oberen Polierteller 210 befindet sich ein Poliertuch 120. Der Polierteller 110 wird zusammen mit dem Poliertuch 120 in Richtung des Polier-bzw. Anpressdruckes p1 gegen die Läuferscheiben 130, die Halbleiterscheiben 600 und den unteren Polierteller 111 mit dem Poliertuch 121 gedrückt.

Mit den Rotationsgeschwindigkeiten ω1 und ω2 können der obere Polierteller 110 bzw. der untere Polierteller 111 gedreht bzw. rotiert werden. Hier sind die beiden Rotationsgeschwindigkeiten entgegengesetzt dargestellt, diese können jedoch beispielsweise und je nach Anwendung auch die gleiche Rotationsrichtung, aber unterschiedliche Beträge aufweisen. Ebenso ist es denkbar, die Rotationsgeschwindigkeiten während des Betriebs - ebenso wie den Anpress- bzw. Polierdruck - zu verändern. Zum Polieren kann dabei ein geeignetes Poliermittel auf die Poliertücher aufgebracht werden.

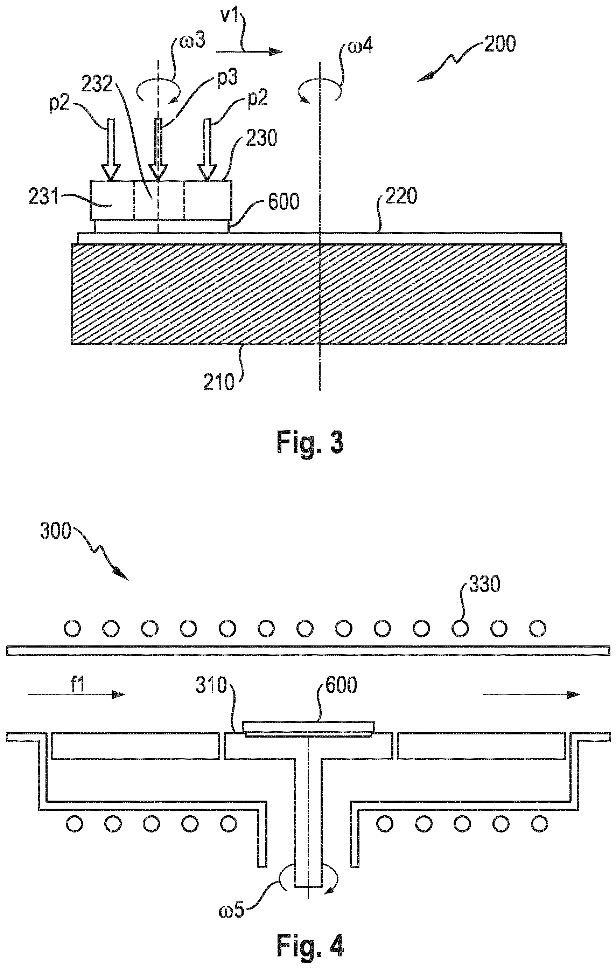

In Figur 3 ist schematisch und detaillierter als in Figur 1 eine (zweite) Poliervorrichtung 200 (für CMP) in einer bevorzugten Ausführungsform, wie sie im Rahmen eines Verfahrens verwendet werden kann, im Querschnitt dargestellt. Die Halbleiterscheibe 600 ist hier auf einem Poliertuch 220 aufgebracht, welches wiederum an einem Polierteller 210 angeordnet ist. Mittels eines Trägers 230 wird die Halbleiterscheibe 600 dabei auf das Poliertuch 220 gedrückt. Während des Polierens dreht sich der Träger 230 dabei um eine erste Achse mit der Rotationsgeschwindigkeit ω3, und der Polierteller 210 dreht sich um eine zweite Achse mit der Rotationsgeschwindigkeit ω4. Zudem kann der Träger mit einer Radialgeschwindigkeit v1 bewegt werden (sowohl nach innen als auch nach außen). Zum Polieren kann dabei ein geeignetes Poliermittel auf die Poliertücher aufgebracht werden.

Insbesondere ist zudem vorgesehen, dass mittels des Trägers 230 die auf die Halbleiterscheibe 600 ausübbaren Drücke unterschiedlich für unterschiedliche Bereiche eingestellt werden können. Im gezeigten, vereinfachten Beispiel kann ein Druck p2 im radial äußeren Bereich 231 und ein Druck p3 im radial inneren Bereich 232 ausgeübt werden. Insbesondere diese Drücke p2 und p3 kommen dabei als Betriebsparameter für die zweite Poliervorrichtung in Frage. Ebenso denkbar ist es, sowohl die Rotationsgeschwindigkeiten ω3 und ω4 als auch die Radialgeschwindigkeit v1 zusätzlich oder alternativ als Betriebsparameter zu verwenden.

Die Drücke können dabei so gewählt werden, dass beispielsweise der Druck p2 größer als der Druck p3 ist. Insbesondere können die Drücke aber auch gezielt hinsichtlich ihres Betrags vorgegeben werden. Es versteht sich, dass in radialer Richtung auch noch mehr unterschiedliche Bereiche vorgesehen sein können, bei denen der Druck individuell einstellbar ist.

In Figur 4 ist schematisch und detaillierter als in Figur 1 eine Beschichtungsvorrichtung 300 in einer bevorzugten Ausführungsform, hier als Gasphasen-Epitaxie-Reaktor, wie sie im Rahmen eines Verfahrens verwendet werden kann, im Querschnitt dargestellt. In der Mitte der Beschichtungsvorrichtung 300 befindet sich ein Suszeptor 310, auf welchem eine zu beschichtende Halbleiterscheibe 600 angeordnet, d.h. abgelegt werden kann. Der Suszeptor 310 weist dabei eine mittige Vertiefung auf, sodass die Halbleiterscheibe 600 beispielsweise nur im Bereich weniger Millimeter ihres Randes auf dem Suszeptor 310 aufliegt.

Durch den Epitaxie-Reaktor 300 kann Gas geleitet werden, im vorliegenden Beispiel von einer Öffnung auf der linken Seite bis zu einer Öffnung auf der rechten Seite des Epitaxie-Reaktors 300, wie dies durch zwei Pfeile angedeutet ist. Mittels Wärmeerzeugungsmitteln, bspw. Heizlampen 330 auf der oberen und der unteren Seite des Epitaxie-Reaktors 300, von denen beispielhaft eine mit einem Bezugszeichen versehen ist, können das durch den Epitaxie-Reaktor 300 geleitete Gas und die Halbleiterscheibe je nach Bedarf auf eine gewünschte Temperatur gebracht werden.

Im Rahmen eines Beschichtungsvorgangs wird nun in einem Ätzschritt ein Ätzgas, beispielsweise eine Mischung von Chlorwasserstoff und Wasserstoff, durch den Epitaxie-Reaktor 300 geleitet, so dass die Halbleiterscheibe vor einem ggf. nachfolgenden Abscheideschritt gezielt vorbehandelt wird. Ohne solchen nachfolgenden Abscheideschritt kann beispielsweise auch nur ein gezielter Abtrag von Material erfolgen. Bevorzugt kann dabei der Volumenstrom von Chlorwasserstoff auf 4 slm und der Volumenstrom von Wasserstoff auf 50 slm eingestellt werden.

Zum Beschichten einer Halbleiterscheibe 600 bzw. zum epitaktischen Abscheiden einer Schicht wird nun ein Abscheidegas, bspw. Trichlorsilan, ggf. gemischt mit Wasserstoff, durch den Epitaxie-Reaktor 300 geleitet. Volumenstrom f1 und/oder Zeitdauer des Durchleitens und/oder Temperatur können hierbei beispielsweise je nach gewünschter Dicke der epitaktisch abzuscheidenden Schicht auf der Halbleiterscheibe 600 als Betriebsparameter eingestellt werden. Zudem kann der Suszeptor 310 mit der darauf angeordneten Halbleiterscheibe 600 mit einer vorgebbaren Rotationsgeschwindigkeit ω5, die alternativ oder zusätzlich ebenfalls als Betriebsparameter in Frage kommt, um eine Achse rotiert werden, wie dies in der Figur angedeutet ist. Auf diese Weise kann ein gleichmäßiges Abscheiden der epitaktischen Schicht erreicht werden.

Im Rahmen eines Beschichtungsvorgangs kann vor dem Durchleiten des Abscheidegases in einem Ätzschritt ein Ätzgas, beispielsweise eine Mischung von Chlorwasserstoff und Wasserstoff, durch den Epitaxie-Reaktor 300 geleitet werden, so dass die Halbleiterscheibe vor dem eigentlichen Beschichtungsvorgang gezielt vorbehandelt wird. Bevorzugt kann dabei der Volumenstrom von Chlorwasserstoff auf 4 slm und der Volumenstrom von Wasserstoff auf 50 slm eingestellt werden.

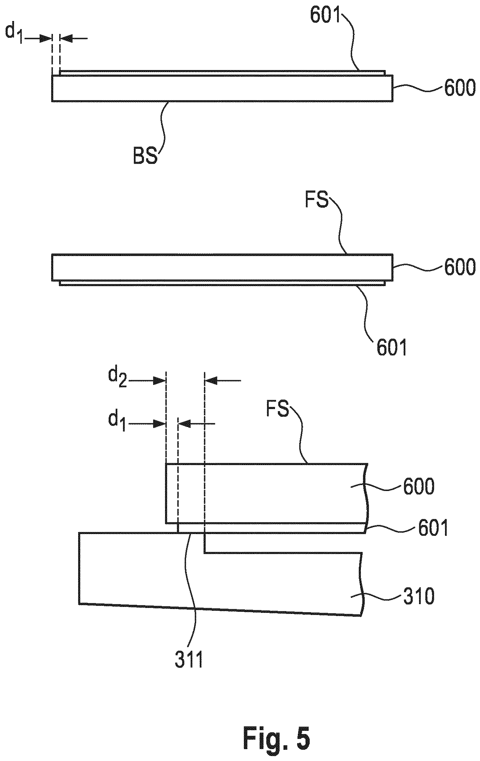

In Figur 5 ist eine Halbleiterscheibe 600 in verschiedenen Ansichten dargestellt, wie sie bei einem Verfahren in verschiedenen bevorzugten Ausführungsformen verwendet werden kann.

In der oberen Ansicht ist einer ersten Seite (FS) von zwei Seiten der Halbleiterscheibe 600, eine Schutzschicht 601, beispielsweise Siliziumdioxid, aufgebracht. Siliziumdioxid kann dabei beispielsweise durch übliche Verfahren, bei denen die Schicht dann als LTO-Schicht (Low Temperatur Oxide) vorliegt, aufgebracht werden. Die zweite Seite (BS) der zwei Seiten, ist nicht beschichtet.

Die Schutzschicht 601 ist hier bis zu einem Randausschluss d₁, der beispielsweise 0,1 mm betragen kann, vorgesehen.

In der mittleren Ansicht ist auf der zweiten Seite (BS) der Halbleiterscheibe 600 eine Schutzschicht 601, beispielsweise ebenfalls Siliziumdioxid, aufgebracht. Die erste Seite (FS) ist nicht beschichtet.

In der unteren Ansicht ist die Halbleiterscheibe 600 nun auf den Suszeptor 310 der Beschichtungsvorrichtung bzw. des Epitaxie-Reaktors 300 aufgebracht, wie dies ähnlich bereits in Figur 4 gezeigt ist. Dabei ist auf der zweiten Seite (BS) die Schutzschicht 601 aufgebracht, mit welcher die Halbleiterscheibe 600 dann auch in einem Auflagebereich 311 des Suszeptors 310 auf dem Suszeptor 310 aufliegt. Die Halbleiterscheibe überlappt mit dem Auflagebereich 311 bzw. dem Suszeptor 310 dabei in radialer Richtung um ein Maß d₂. Dieses Maß d₂ kann dabei beispielsweise 1 mm betragen. Hierzu sei angemerkt, dass die Figuren nicht maßstabsgetreu sind, vielmehr sind einzelne Maße übertrieben dargestellt.

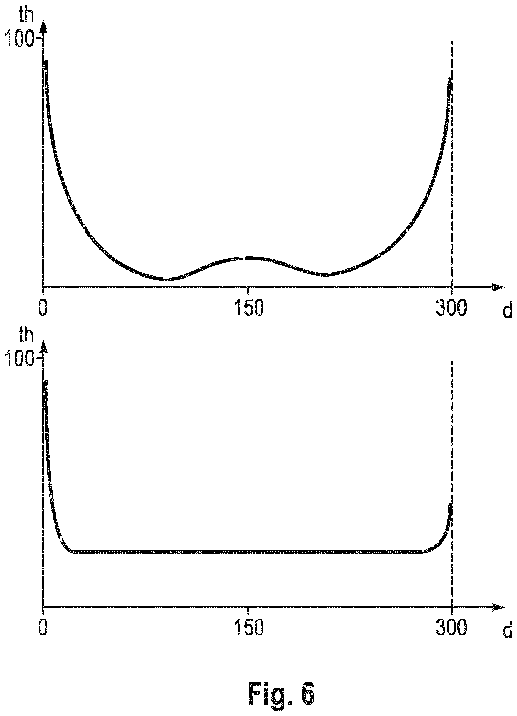

In Figur 6 ist jeweils der radiale Verlauf des Dickenunterschieds th in nm über den Durchmesser d in mm zweier Halbleiterscheiben nach Durchlaufen einer Beschichtungsvorrichtung im Rahmen eines Verfahrens dargestellt, hier jeweils nach einem Ätzschritt in der Beschichtungsvorrichtung mit einer Dauer von 60 s, bei dem eine Seite mit der Halbleiterscheibe mit einer Schutzschicht abgedeckt war. Der Dickenunterschied ergibt sich durch den Vergleich der Dicke der jeweiligen Halbleiterscheibe, die vor und nach dem Ätzschritt gemessen wird. Aus Gründen der Lesbarkeit der Grafik wurde ein globaler Offset derart subtrahiert, dass das Minimum der Scheibendicke nahe bei Null liegt.

Die Zeichnung oben zeigt einen typischen Verlauf des Dickenunterschieds, der sich ergibt, wenn während des Ätzschritts die zweite Seite (BS) mit der Schutzschicht bedeckt ist und diese Seite diejenige ist, die dem Suszeptor zugewandt ist. Hier ist deutlich zu sehen, dass in radialer Richtung Unterschiede beim Abtrag auftreten. Aufgrund der Schutzschicht handelt es sich dabei um Abtrag von Material, das im Wesentlichen von der ersten Seite (FS) abgetragen wird.

Die Zeichnung unten zeigt einen typischen Verlauf des Dickenunterschieds, wenn während des Ätzschritts die erste Seite (FS) mit der Schutzschicht bedeckt ist und die zweite Seite (BS) diejenige ist, die dem Suszeptor zugewandt ist. Hier ist deutlich zu sehen, dass während des Ätzschritts Material sehr nahe dem Rand, also insbesondere im Bereich der Auflage auf dem Suszeptor, wie dies in Figur 5 unten gezeigt ist, selektiv aufgewachsen wird. Aufgrund der Schutzschicht auf der ersten Seite (FS) handelt es sich dabei um Material, das im Wesentlichen auf der zweiten Seite (BS) abgeschieden wird.

Durch das vorgeschlagene Verfahren ist es daher insbesondere möglich, die beiden Seiten der Halbleiterscheibe getrennt voneinander zu bearbeiten, und die Wikungsweisen von Material-Enfernung und Material-Aufwachsung getrennt voneinander und kontrolliert zu nutzen. Insbesondere kann dabei für jeden Bearbeitungsvorgang ein auf die Bearbeitung einer Seite zugeschnittener Satz an Betriebsparametern eingestellt werden. Ohne Schutzschicht wäre das nicht möglich, weil mit dem Bearbeitungsvorgang die Beschaffenheit beider Seiten gleichzeitig verändert werden würde, unabhängig von den gewählten Betriebsparametern.

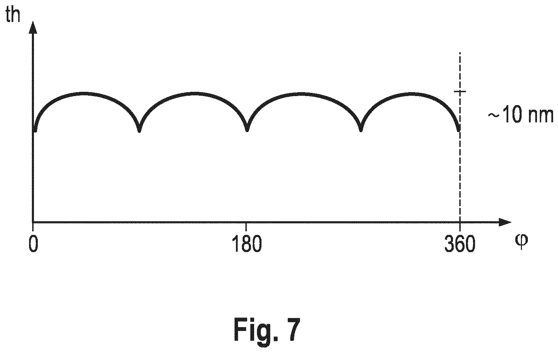

Figur 7 zeigt schematisch einen typischen Verlauf des Dickenunterschieds th in Umfangsrichtung (über den Polarwinkel ϕ in ° bei einem Radius um etwa 148 mm) einer Halbleiterscheibe mit bereits erwähnter {100}-Orientierung nach Durchlaufen eines Ätzschritts in einer Beschichtungsvorrichtung, wenn während des Ätzschritts die zweite Seite (BS) mit der Schutzschicht bedeckt ist und die zweite Seite (BS) diejenige ist, die dem Suszeptor zugewandt ist.

Es sind deutlich vier jeweils um 90° versetzte Bereiche zu erkennen, in denen der Abtrag deutlich größer ist. Aufgrund der Kristallstruktur ergibt es sich, dass hier der Abtrag bei Anwendung des Ätzgases größer ist, als in den dazwischen liegenden Bereichen. Der Dickenunterschied beträgt etwa 10 nm. Die Lage der Bereiche mit dem größeren Abtrag am Umfang der Halbleiterscheibe stimmt mit der Lage der vier Bereiche überein, wo eine epitaktische Schicht schneller aufwächst. Dieses Ergebnis kann genutzt werden, vorzugsweise indem der Ätzschritt und der Abscheideschritt mit dem Ziel kombiniert werden, dass der größere Materialabtrag im Zuge des Ätzschritts und die größere Matrialzunahme im Zuge des Abscheideschritts dazu führt, dass die Dicke der epitaktisch beschichteten Halbleiterscheibe in Umfangsrichtung nahezu gleichmäßig ist und einen gewünschten Wert hat.

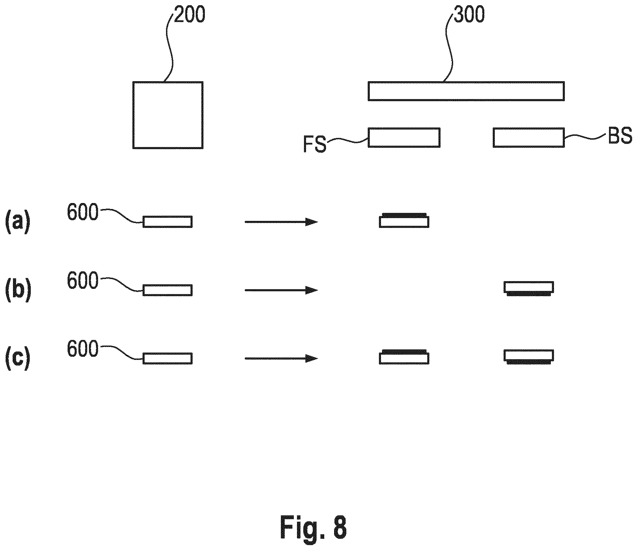

In Figur 8 sind nun schematisch die Abläufe von drei bevorzugten Ausführungsformen des Verfahrens dargestellt. Ungeachtet dessen gehören zur Erfindung auch Ausführungsformen, die eine nicht gezeigte Kombination aus Beschichten einer bestimmten Seite der Halbleiterscheibe mit einer Schutzschicht und Ablegen einer bestimmten Seite auf dem Suszeptor der Beschichtungsvorrichtung betreffen, damit diese Seite dem Suszeptor zugewandt liegt. Die gezeigten bevorzugten Ausführungsformen (a), (b) und (c) umfassen hier zunächst einen Poliervorgang mittels der Poliervorrichtung 200. Es versteht sich, dass dem Poliervorgang (hier CMP) auch noch andere Bearbeitungsvorgänge (auch andere Poliervorgänge wie insbesondere ein DSP-Poliervorgang, bei dem beide Seiten gleichzeitig poliert werden) vorausgegangen sein können. Die polierte Halbleiterscheibe hat ein radiales Dickenprofil.

Im Zuge der ersten bevorzugten Ausführungsform (a) wird in der Beschichtungsvorrichtung ein Ätzschritt vorgenommen, wobei die erste Seite (FS) der Halbleiterscheibe mit der Schutzschicht versehen und derart auf dem Suszeptor abgelegt wird, dass die zweite Seite (BS) dem Suszeptor zugewandt liegt.

Auf diese Weise kann durch den Ätzschritt gezielt am Rand der zweiten Seite (BS) Material abgeschieden werden, beispielsweise um einen Randabfall, der durch eine vorhergehende Politur erzeugt wurde, entgegenzuwirken. Nach dem Entfernen der Schutzschicht resultiert eine Halbleiterscheibe mit mindestens einer durch CMP polierten Seite und besonders einheitlicher Dicke, insbesondere im Randbereich. Insbesondere wird ein vergleichsweise niedriger ESFQRmax-Wert auch bei geringem Randausschluss erreicht.

Gemäß der zweiten bevorzugten Ausführungsform (b) wird in der Beschichtungsvorrichtung ein Ätzschritt vorgenommen, wobei die zweite Seite (BS) der Halbleiterscheibe mit der Schutzschicht versehen wird und die Halbleiterscheibe derart auf dem Suszeptor abgelegt wird, dass die zweite Seite dem Suszeptor zugewandt liegt. Auf diese Weise kann gezielt Material von der ersten Seite (FS) abgetragen werden, beispielsweise mit dem Ziel die Voraussetzungen dafür zu schaffen, dass bei einem nachfolgenden Abscheiden einer epitaktischen Schicht auf der ersten Seite (FS) möglichst geringe Dickenunterschiede aufgrund der Vierfach-Symmetrie resultieren. Gleichzeitig wird einer ungewollten Aufwachsung von Material entgegengewirkt, die sich negativ auf die lokale Ebenheit der Halbleiterscheibe auswirkt.

Gemäß der dritten bevorzugten Ausführungsform (c) werden die die erste und zweite bevorzugte Ausführungsform (a) und (b) im Wesentlichen kombiniert. Der Ätzschritt ist in einen ersten Ätzschritt und in einen zweiten Ätzschritt untergliedert. Nach dem Poliervorgang wird auf der ersten Seite (FS) eine erste Schutzschicht gebildet, und die Halbleiterscheibe derart auf dem Suszeptor abgelegt, dass die zweite Seite dem Suszeptor zugewandt liegt. Dann wird in der Beschichtungsvorrichtung 300 der erste Ätzschritt vorgenommen, im Zuge dessen Material im Randbereich der zweiten Seite (BS) abgeschieden wird. Anschließend wird die erste Schutzschicht von der ersten Seite (FS) entfernt und eine zweite Schutzschicht auf der zweiten Seite (BS) gebildet. Danach wird in der Beschichtungsvorrichtung 300 der zweite Ätzschritt vorgenommen, im Zuge dessen Material von der ersten Seite (FS) abgetragen wird. Nach dem zweiten Ätzschritt wird der Abscheideschritt in der Beschichtungsvorrichtung vorgenommen, im Zuge dessen auf der ersten Seite (FS) eine epitaktische Schicht abgeschieden wird.

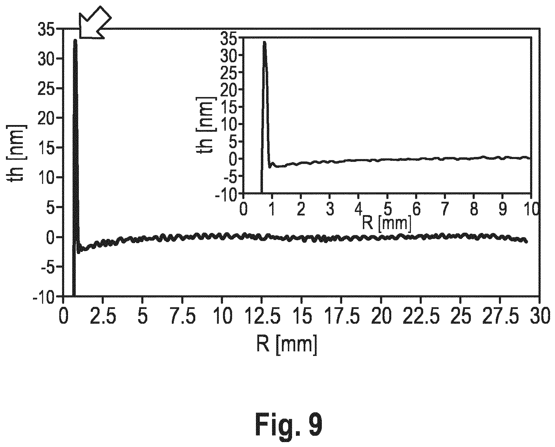

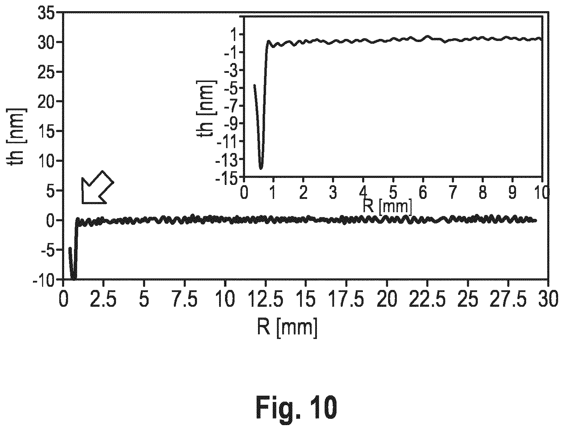

Figur 9 und Fig. 10 zeigen an zwei epitaktisch beschichteten Halbleiterscheiben Messergebnisse zu Dickenunterschieden th im Randbereich. Gezeigt ist jeweils der Verlauf des jeweiligen Dickenunterschieds, der sich nach einem Ätzschritt mit der Dauer von 60 s ergibt, je nach Art der Durchführung des Verfahrens. Der Dickenunterschied kommt durch einen Vergleich der Dicke der jeweiligen Halbleiterscheibe im Zustand vor und nach dem Ätzschritt zustande. In einer kleineren Abbildung ist der kritische Verlauf im Abstand R zum Rand der Halbleiterscheibe vergrößert hervorgehoben.

Wird gemäß der ersten bevorzugten Ausführungsform vorgegangen, also liegt die Halbleiterscheibe während des Ätzschritts mit Chlorwasserstoff so auf dem Suszeptor, dass die zweite Seite (BS) dem Suszeptor zugewandt ist und trägt die erste Seite (FS) eine Schutzschicht, ist ein typischer steiler Anstieg des Dickenverlaufs im Randbereich zu erkennen, der durch einen Pfeil hervorgehoben ist (Fig.9). Es ist eben dieser steile Anstieg im Dickenverlauf, der speziell bei epitaktisch beschichteten Halbleiterscheiben nach dem Stand der Technik die erreichbare Ebenheit bei kleinem Randausschluss (< 2 mm) maßgeblich limitiert.

Wird gemäß der zweiten bevorzugten Ausführungsform vorgegangen, also liegt die Halbleiterscheibe während des Ätzschritts so auf dem Suszeptor, dass die zweite Seite (FS) dem Suszeptor zugewandt ist und trägt die zweite Seite eine Schutzschicht (BS), bleibt die Halbleiterscheibe während des Aufheiz- und Ätzvorgangs nahezu gleichmäßig flach, was ebenfalls durch einen Pfeil hervorgehoben ist (Fig.10). Dieser Vorteil erlaubt die Fertigung von Halbleiterscheiben mit überlegener Ebenheit/Flachheit bei einem Randausschluss von 2 mm und bis hin zu kleinsten Randausschlüssen von < 0.5mm.

Zusätzlich kann zur Durchführung jeder Ausführungsform vorgesehen werden, für jeden Bearbeitungsvorgang (beispielsweise Politur durch DSP, Politur durch CMP, Ätzschritt(e) und Abscheiden einer epitaktischen Schicht (EPI)) wenigstens einen Betriebsparameter des jeweiligen Bearbeitungsvorgangs vorzugeben, und zwar basierend auf wenigstens einem Scheibenparameter, der an der zu bearbeitenden Halbleiterscheibe ermittelt wird;
basierend auf einem Ist-Zustand einer Bearbeitungsvorrichtung, mit der der jeweilige Bearbeitungsvorgang durchgeführt wird; und
basierend auf einer Optimierung von Scheibenparametern zur Charakterisierung der Ebenheit hinsichtlich deren Zustands nach dem Durchlaufen der drei Bearbeitungsvorgänge an Stelle einer Optimierung dieser Scheibenparameter hinsichtlich deren Zustands nach jedem einzelnen der drei Bearbeitungsschritte.

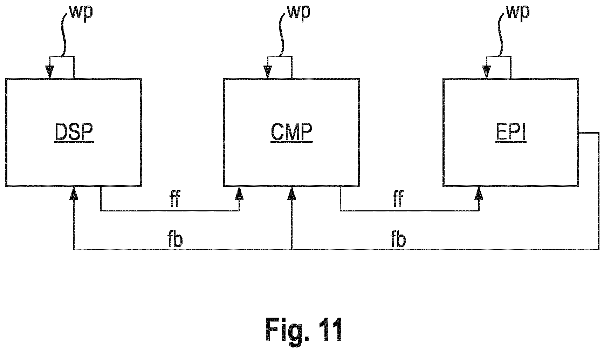

In Figur 11 ist das stellvertretend für die Bearbeitungsschritte DSP, CMP und EPI dargestellt. Für jeden der drei Bearbeitungsvorgänge wird Information bereitgestellt, um wenigstens einen Betriebsparameter, der für die jeweilige Bearbeitungsvorrichtung spezifisch ist, vorgeben zu können:
Es wird wenigstens ein Scheibenparameter an der zu bearbeitenden Halbleiterscheibe ermittelt, um mindestens einen Betriebsparameter für den nachfolgenden Bearbeitungsvorgang vorzugeben (cross-process feed forward, ff).

Es wird der Ist-Zustand der jeweiligen Bearbeitungsvorrichtung (DSP, CMP, EPI) an Hand der bearbeiteten Halbleiterscheibe beurteilt, und darauf basierend wird mindestens ein Betriebsparameter der beurteilten Bearbeitungsvorrichtung für die Bearbeitung einer nachfolgenden Halbleiterscheibe mit dieser Bearbeitungsvorrichtung vorgegeben (within process feed back, wp).

Nach Durchlauf der drei Bearbeitungsvorgänge werden Parameter der bearbeiteten Halbleiterscheibe betrachtet, die deren Ebenheit charakterisieren, beispielsweise ESFQRₘₐₓ und SFQRₘₐₓ und mit jeweiligen Zielwerten verglichen, um mindestens einen Betriebsparameter für einen oder mehrere der drei Bearbeitungsvorgänge zur Bearbeitung einer nachfolgenden Halbleiterscheibe vorzugeben (cross-process feedback, fb).

## Patentansprüche

1. Halbleiterscheibe (600), insbesondere Siliziumscheibe, mit einem ESFQRₘₐₓ-Wert von höchstens 5 nm bei einem Randausschluss (R₁) von höchstens 2 mm und 72 Sektoren (625) mit jeweils einer Länge (R₂) von 30 mm.

2. Halbleiterscheibe (600) nach Anspruch 1 mit einem ESFQRₘₐₓ-Wert von höchstens 10 nm bei einem Randausschluss (R₁) von höchstens 1 mm und 72 Sektoren (625) mit jeweils einer Länge (R₂) 30 mm.

3. Halbleiterscheibe (600) nach Anspruch 1 mit einem ESFQRₘₐₓ-Wert von höchstens 15 nm bei einem Randausschluss (R₁) von höchstens 0,5 mm und 72 Sektoren (625) mit jeweils einer Länge (R₂) 30 mm.
